# FASCICULE DE BREVET EUROPEEN

(11) **EP 1 641 709 B1**
(45) Date de publication et mention de la délivrance du brevet: **11.04.2007**
(21) Numéro de dépôt: 04767542.6
(22) Date de dépôt: 01.07.2004
(51) Int. Cl.: B81B 3/00, B81C 1/00

(54) **PROCEDE DE DESOLIDARISATIO D'UNE COUCHE UTILE ET COMPOSANT OBTENU PAR CE PROCEDE**
VERFAHREN ZUM TRENNEN EINER NÜTZLICHEN SCHICHT UND DURCH DAS VERFAHREN ERHALTENE KOMPONENTE
METHOD FOR SEPARATING A MOBILE DEVICE LAYER AND COMPONENT OBTAINED BY SAID METHOD

(30) Priorité: 04.07.2003 FR 0308157
(43) Date de publication de la demande: 05.04.2006
(73) Titulaire: COMMISSARIAT A L'ENERGIE ATOMIQUE, 75752 Paris Cédex 15 (FR)
(72) Inventeur: GRANGE, Hubert, F-38100 Grenoble (FR); DIEM, Bernard, F-38130 Echirolles (FR); VIOLLET, Bosson, Yylvie, F-38450 VIF (FR); BOREL, Michel, F-38660 Saint Vincent de Mercuze (FR)
(74) Mandataire: Jouvray, Marie-Andrée
(86) Numéro de dépôt international: PCT/FR2004/001699
(87) Numéro de publication internationale: WO 2005/012160

(56) Documents cités:
- EP-A- 0 456 029
- US-A- 5 489 556
- US-A- 5 750 420
- US-A- 5 824 608
- US-A- 6 004 832
- ALLEY R L ET AL: "The effect of release-etch processing on surface microstructure stiction" SOLID-STATE SENSOR AND ACTUATOR WORKSHOP, 1992. 5TH TECHNICAL DIGEST., IEEE HILTON HEAD ISLAND, SC, USA 22-25 JUNE 1992, NEW YORK, NY, USA,IEEE, US, 22 juin 1992 (1992-06-22), pages 202-207, XP010056353 ISBN: 0-7803-0456-X

## Description

### Domaine technique de l'invention

L'invention concerne un procédé de désolidarisation d'une couche utile, reliée initialement par une couche sacrificielle à une couche constituant un substrat, procédé comportant
- la gravure, au moins partielle, de la couche sacrificielle,
- le dopage, avant gravure de la couche sacrificielle, d'au moins une partie de la surface d'au moins l'une des couches en contact avec la couche sacrificielle et,
- après gravure de la couche sacrificielle, une phase de gravure superficielle de ladite surface, de manière à augmenter la rugosité de la partie dopée de la surface.

### État de la technique

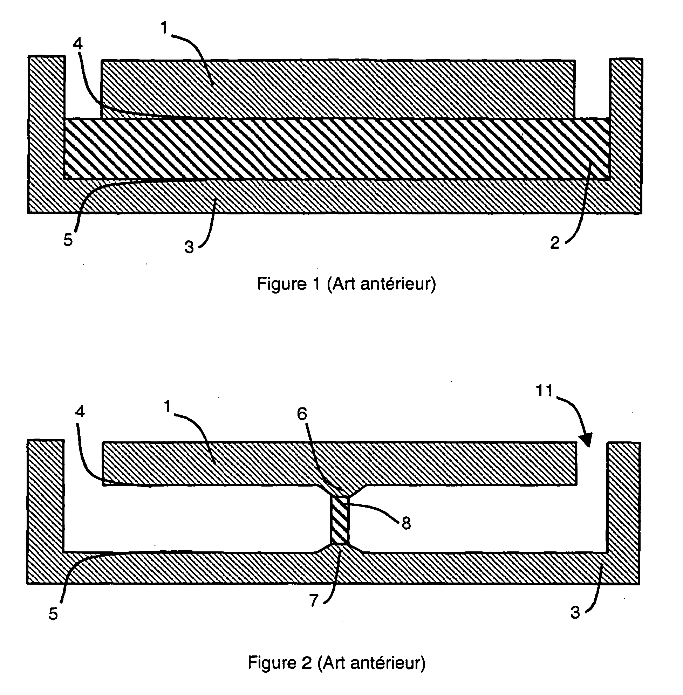

Certains composants micromécaniques, par exemple des actionneurs ou des accéléromètres, comportent une couche utile suspendue, rattachée par des moyens de fixation à un substrat. L'écart entre la couche utile et le substrat peut être de l'ordre de, ou inférieur au micron. Dans ce cas, le composant est généralement fabriqué au moyen d'une couche sacrificielle, ce qui permet de contrôler l'écart entre la couche utile et le substrat. Comme représenté sur la figure 1, la couche utile 1 est reliée initialement par la couche sacrificielle 2 à une couche constituant un substrat 3. Lors du procédé de fabrication, la couche sacrificielle 2 est gravée, au moins partiellement, pour obtenir une structure suspendue.

La gravure est typiquement effectuée par voie chimique liquide, suivie éventuellement d'un rinçage. Après la gravure et le rinçage, le composant est séché et des forces capillaires peuvent rapprocher la couche utile 1 du substrat 3 et, ainsi, provoquer le collage de leurs surfaces opposées 4 et 5, ce qui rend le composant inutilisable. D'autres forces, par exemple des forces électrostatiques ou des forces de Van der Waals, peuvent également conduire au collage des surfaces 4 et 5.

A la figure 2, le collage des surfaces 4 et 5 est évité par des butées 6 et 7, respectivement solidaires des surfaces 4 et 5 et maintenant à distance les deux surfaces 4 et 5. Le document US5750420 décrit un procédé de fabrication d'une telle structure, dans laquelle la couche utile 1 est maintenue à distance du substrat 3 par des butées 6 et 7. Il comporte une gravure partielle de la couche sacrificielle 2, laissant subsister un pavé 8 espaceur, d'une largeur de l'ordre du micron, puis une gravure partielle de la couche utile 1, de manière à former les butées 6 et 7, et ensuite une gravure d'élimination du pavé 8 espaceur. Ce procédé nécessite ainsi trois étapes de gravure, dont la première est difficile à maîtriser. La disposition du pavé 8 espaceur, et en conséquence des butées, est déterminée par des fronts de gravure se propageant à partir d'orifices latéraux 11.

L'article "The effect of release-etch processing on surface microstructure stiction" de R.L. Alley et al. (Solid-State Sensor and Actuator Workshop, 5^{th} technical digest., 22 juin 1992, pages 202-207) décrit un procédé permettant de désolidariser des microstructures par gravure et mentionne que la rugosité de surface permet d'augmenter la séparation entre surfaces. Une structure suspendue, initialement reliée par une couche sacrificielle à un substrat fortement dopé est désolidarisée par gravure de la couche sacrificielle, par exemple en utilisant de l'acide fluorhydrique. Le substrat peut être constitué par un matériau dopé n ou par un matériau dopé p, par exemple par un procédé utilisant du B₂O₂. La structure suspendue comporte une couche en poly-silicium dopé par de l'azote, pendant une heure à 1050°C. Après la gravure de la couche sacrificielle, le poly-silicium dopé n est beaucoup plus rugueux qu'un matériau amorphe utilisé dans un test de comparaison.

Le document US6004832 décrit un procédé de fabrication d'une couche de nitrure suspendue sur un substrat conducteur. La couche de nitrure est d'abord déposée sur une couche isolante qui est gravée au moins partiellement. Ensuite, la surface du substrat, constitué par un matériau fortement dopé, est rendue rugueuse par voie chimique, par exemple en utilisant de d'hydroxyde de potassium (KOH).

### Objet de l'invention

L'invention a pour but de remédier aux inconvénients des procédés connus et, plus particulièrement, d'éviter le collage de la couche utile et du substrat, tout en simplifiant le procédé de fabrication.

Selon l'invention, ce but est atteint par les revendications annexées et, plus particulièrement, par le fait que le procédé comporte, avant dopage, le dépôt d'un masque sur au moins une partie prédéterminée de la couche utile, de manière à délimiter au moins une zone dopée et au moins une zone non-dopée de ladite surface, l'une desdites zones constituant une butée après la phase de gravure superficielle.

L'invention a également pour but un composant comportant une couche utile suspendue, rattachée par des moyens de fixation à un substrat, caractérisé en ce qu'il est obtenu par un procédé selon invention.

### Description sommaire des dessins

D'autres avantages et caractéristiques ressortiront plus clairement de la description qui va suivre de modes particuliers de réalisation de l'invention donnés à titre d'exemples non limitatifs et représentés aux dessins annexés, dans lesquels :
Les figures 1 et 2 représentent un composant selon l'art antérieur, respectivement avant et après gravure de la couche sacrificielle.
Les figures 3 et 4 représentent des étapes de dopage d'un mode de réalisation particulier d'un procédé selon l'invention.
La figure 5 représente une étape d'épitaxie d'un mode de réalisation particulier d'un procédé selon l'invention.
Les figures 6 à 8 illustrent différentes étapes de gravure d'un mode de réalisation particulier d'un procédé selon l'invention.

### Description de modes particuliers de réalisation

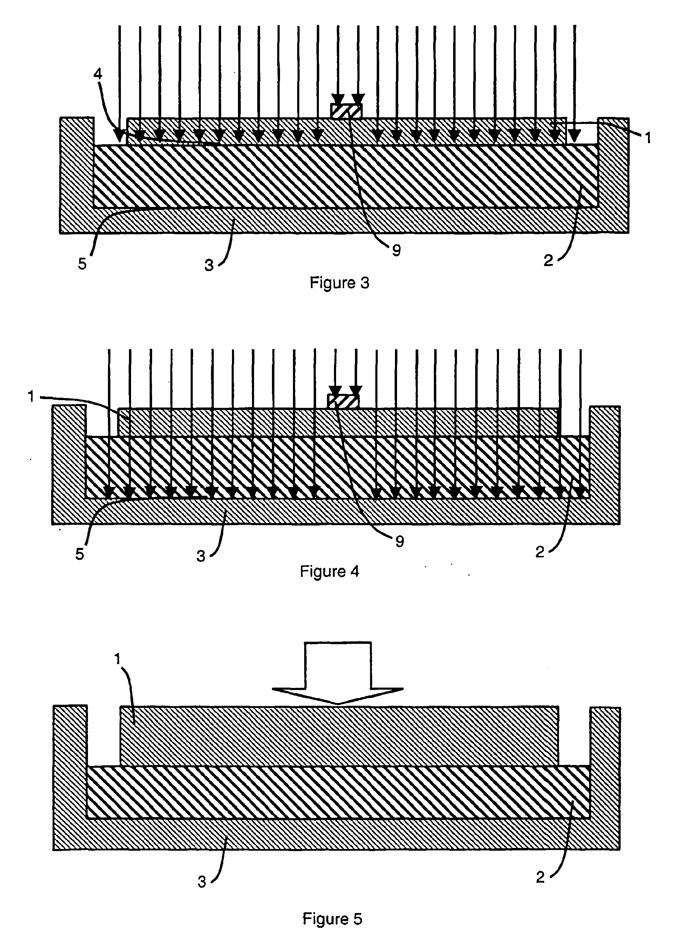

Sur la figure 3, la couche utile 1, en silicium, est initialement reliée par la couche sacrificielle 2, en silice, à la couche 3 constituant le substrat de silicium. Comme représenté par des flèches à la figure 3, une première étape d'un procédé de désolidarisation de la couche utile 1, consiste à doper la surface inférieure 4 de la couche utile 1, disposée en contact avec la couche sacrificielle 2. Le dopage est effectué à travers la couche utile 1.

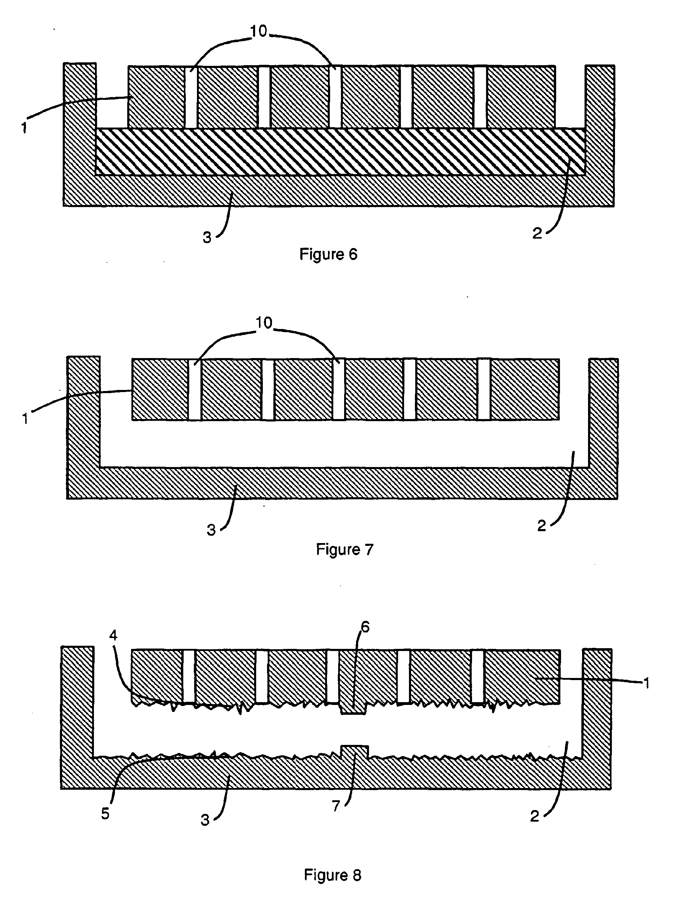

La surface de silicium dopée a la propriété de se graver plus rapidement qu'une surface de silicium non-dopée et, de plus, avec une rugosité plus importante. Ainsi, après gravure complète de la couche sacrificielle, une phase de gravure superficielle de la surface 4 augmente la rugosité de la partie dopée de la surface (figure 8), ce qui permet de réduire les forces d'adhérence entre les surfaces opposées de la couche utile et de la couche constituant le substrat et, ainsi, d'éviter, ou au moins de limiter, le collage de la couche utile et du substrat.

Dans le mode de réalisation représenté à la figure 3, un masque 9 est déposé avant dopage sur une partie centrale de la face supérieure de la couche utile 1. Ainsi, le masque 9 délimite une zone non dopée de la surface inférieure 4 de la couche utile 1. Cette zone non dopée se gravant moins rapidement que les zones dopées, elle constitue une butée 6 en fin de procédé, après la phase de gravure superficielle (figure 8).

Dans une deuxième étape de dopage du procédé, représentée à la figure 4, la surface 5 supérieure de la couche 3 de substrat peut être partiellement dopée. Comme précédemment, un masque 9 peut délimiter une zone centrale non dopée.

Les étapes de dopage sont, de préférence, effectuées par implantation ionique, les éléments dopants étant pris dans le groupe comprenant le Bore, le Phosphore et l'Arsenic. L'énergie des ions détermine la profondeur de pénétration dans le matériau et permet, ainsi, de doper sélectivement la surface inférieure 4 de la couche utile 1 et la surface supérieure 5 de la couche 3 constituant le substrat. Par exemple, une surface de silicium dopé intrinsèquement par du bore (dopage de type P) et ayant une résistivité de 1Ω.cm, est dopée par du bore par implantation ionique avec une énergie de 45 keV et une dose de 5x10¹⁵ atomes/cm² sur une épaisseur de 0,3 µm, donnant une résistivité de 1,5. 10⁻³ Ω.cm pour l'épaisseur de 0,3 µm de la surface inférieure 4 de la couche utile 1. Une implantation ionique de bore appliquée sur le même type de silicium, à travers une couche utile 1 de silicium de 0,21 µm et une couche sacrificielle 2 de silice de 0,4 µm, est effectuée, par exemple, avec une énergie de 240 keV et une dose de 2x10¹⁴ atomes/cm², donnant une résistivité de 0,01Ω.cm sur une épaisseur de 0,3 µm de la surface supérieure 5 de la couche 3 constituant le substrat.

Les doses, les énergies et les épaisseurs de dopage peuvent être adaptées aux épaisseurs à traverser, à la rugosité souhaitée, à la sélectivité souhaitée de gravure du silicium dopé par rapport au silicium non-dopé et à l'épaisseur à graver, qui dépend, en revanche, de la solution de gravure utilisée et du temps de gravure. La résistivité des zones dopées est typiquement 10 ou 1000 fois plus élevée que celle des zones non-dopées, mais ce rapport peut être plus important ou moins important suivant le type de dopage et les solutions de gravure utilisées.

Par ailleurs, un dopage trop faible ne permet pas d'obtenir la rugosité souhaitée, tandis que dans le cas d'un dopage en excès, le matériau se grave trop rapidement et, ainsi, le contrôle de la gravure et de la rugosité est plus difficile. Cependant, un dopage en excès peut être utilisé pour éliminer complètement la partie dopée.

Afin d'améliorer le rendement des étapes de dopage, la couche utile 1 initiale (figures 3 et 4) est, de préférence, plus fine que la couche utile finale souhaitée (figures 5 à 8). Après dopage, l'épaisseur de la couche utile 1 peut ainsi être augmentée par une étape d'épitaxie, représentée à la figure 5, utilisant généralement le même matériau que celui de la couche utile 1 initiale, c'est-à-dire typiquement du silicium, mais pas nécessairement le même type de dopage. La résistivité des matériaux peut être déterminée respectivement par un taux de dopage bien maîtrisé. L'épaisseur finale de la couche utile 1 finale est typiquement de l'ordre de 20 µm, la couche utile initiale pouvant, par exemple, avoir une épaisseur de l'ordre de 0,3 µm.

Sur la figure 6, des orifices verticaux 10 sont usinés par gravure dans la couche utile 1, pour permettre successivement le passage des solutions de gravure de la couche sacrificielle 2 et de gravure superficielle des surfaces 4 et 5 respectives de la couche utile 1 et de la couche de substrat 3. La géométrie et la disposition des orifices 10 permettent de définir les dimensions de la partie suspendue de la couche utile. La couche utile 1 est suspendue par des moyens de fixation non-représentés.

La couche sacrificielle 2 est typiquement enlevée, comme représenté à la figure 7, par gravure avec des solutions à base d'acide fluorhydrique. La gravure superficielle est typiquement effectuée par une solution de potasse et, préférentiellement, par une solution aqueuse comportant du K₂Cr₂O₇ et du HF, par exemple du type « Secco ». L'épaisseur de la couche superficielle gravée est typiquement comprise entre quelques nanomètres et 1 micron.

Comme illustré à la figure 8 (à une échelle très agrandie), la phase de gravure superficielle de la surface inférieure 4 de la couche utile 1 et de la surface supérieure 5 de la couche de substrat augmente la rugosité des zones dopées.

Les zones éventuelles non-dopées restent plates et sont gravées moins profondément que les zones dopées. Ainsi, les zones non-dopées constituent des butées 6 et 7 disposées en regard, maintenant à distance les deux surfaces opposées 4 et 5, ce qui permet, en combinaison avec la rugosité des surfaces opposées 4 et 5, de limiter davantage le risque du collage des surfaces 4 et 5.

Généralement, la surface inférieure 4 de la couche utile 1 et la surface supérieure 5 de la couche 3 constituant le substrat, comportent intrinsèquement des éléments dopants d'un type prédéterminé, c'est-à-dire un dopage du type N ou du type P. Le dopage représenté aux figures 3 et 4, est effectué par le même type d'éléments dopants et, ainsi, les zones non dopées constituent (figure 8) les butées 6 et 7 en fin de procédé. Dans une variante de réalisation, le dopage peut être effectué par des éléments dopants de type opposé. Dans ce cas, la vitesse de gravure est plus faible dans les zones dopées par les éléments dopants de type opposé que dans les zones non-dopées et les butées sont alors constituées par les zones dopées, en fin de procédé.

Tandis que dans le mode de réalisation représenté à la figure 7, la totalité de la couche sacrificielle est enlevée après dopage et avant la gravure superficielle des surfaces 4 et 5, dans un mode de réalisation particulier, après dopage et avant la phase de gravure superficielle, la couche sacrificielle 2 n'est gravée que partiellement, laissant subsister entre la couche 3 constituant le substrat et la couche utile 1 au moins un pavé 8 espaceur, comme représenté à la figure 2. Comme dans le document US5750420, la phase de gravure superficielle des surfaces 4 et 5 utilise alors le pavé 8 espaceur comme masque, de façon à former les butées 6 et 7 dans les surfaces 4 et 5. Simultanément, elle augmente la rugosité des zones libres dopées des surfaces 4 et/ou 5. De plus, après enlèvement du pavé 8 espaceur, une phase supplémentaire de gravure superficielle des surfaces 4 et 5 peut être réalisée pour augmenter la rugosité de la surface dopée des butées 6 et/ou 7. Ceci permet la formation de butées de dimension plus importante que les butées plates sans augmenter le risque du collage. Ainsi, le contrôle de la gravure partielle de la couche sacrificielle 2, formant le pavé 8 espaceur, est facilité. Le contrôle des dimensions du pavé espaceur sont moins critiques que dans le cas décrit dans le document US5750420 puisque la surface est rugueuse.

Le procédé s'applique, particulièrement, aux couches sacrificielles 2 minces en SiO₂, dont l'épaisseur est comprise entre quelques dizaines de nanomètres et quelques microns et, de préférence, de l'ordre de 400 nanomètres. Par exemple, des substrats 3 du type silicium sur isolant (« silicon on insulator : SOI ») sont particulièrement appropriés, notamment des substrats obtenus par séparation par implantation d'oxygène (« séparation by implantation of oxygen : SIMOX») ayant, de préférence, une épaisseur d'oxyde de 400 nanomètres, ou des substrats du type Unibond® obtenus par le procédé Smart-Cut®, ayant, de préférence, une épaisseur d'oxyde de 1 à 3 microns.

L'invention n'est pas limitée aux modes de réalisation particuliers représentés. En particulier, le dopage d'une seule des surfaces opposées 4 et 5 peut être suffisant pour éviter le collage des surfaces. Le dopage des deux surfaces est utile dans certaines conditions d'utilisation, par exemple dans le cas d'accélérations perpendiculaires élevées ou de différences de potentiel importantes entre les deux surfaces, etc...

Par ailleurs, dans le cas du dopage des deux surfaces opposées 4 et 5, l'une des surfaces peut être complètement dopée, tandis que le dopage de l'autre surface peut être partiel, par exemple à l'aide d'un masque 9. Il est aussi possible d'obtenir une surface rugueuse, sensiblement plane, en regard d'au moins une butée disposée sur l'autre surface. Un tel composant peut être obtenu, par exemple, en enlevant le masque 9 après la première étape de dopage. De manière générale, les différentes étapes de dopage peuvent être effectuées en utilisant des masques différents. Le nombre et la disposition des butées 6 et 7 sur les surfaces 4 et 5 peut être quelconque.

Dans l'art antérieur décrit dans le document US5750420, la disposition de la butée est déterminée par la disposition du pavé espaceur subsistant après la gravure partielle de la couche sacrificielle, disposition déterminée par les fronts de gravure. Contrairement à cet art antérieur, la disposition de la butée du procédé selon l'invention est contrôlée par la disposition du masque déposé sur la couche utile. Il est ainsi possible, par exemple en formant le masque par lithographie, de contrôler très précisément la disposition et la forme des butées 6 et 7. Le masque 9 est délimité, par exemple, par photolithographie, ayant, de préférence, une résolution de l'ordre de 0,3 micromètres. La photolithographie permet de délimiter, avec une bonne reproductibilité, des butées 6 et 7 d'une dimension latérale très précise, dans les plans des surfaces 4 et/ou 5, par exemple d'une dimension latérale de 2 micromètres, à 0,3 micromètres près. La dimension latérale des butées 6 et 7 définit la zone de contact entre les surfaces opposées de la couche utile 1 et du substrat et détermine, ainsi, la force de contact entre la couche utile 1 et le substrat. Le contrôle des dimensions latérales des butées 6 et 7 permet ainsi de contrôler les forces de contact.

Par ailleurs, la hauteur des butées 6 et 7, perpendiculairement aux plans des surfaces 4 et/ou 5, n'influence pas significativement le contact entre la couche utile 1 et les butées 6 et 7. Ainsi, la durée de gravure superficielle des surfaces 4 et 5, qui définit la hauteur des butées sans modifier les dimensions latérales des butées, n'est pas critique. En effet, dû au contraste de dopage, la gravure est fortement sélective.

## Revendications

1. Procédé de désolidarisation d'une couche utile (1), reliée initialement par une couche sacrificielle (2) à une couche (3) constituant un substrat, procédé comportant
- la gravure, au moins partielle, de la couche sacrificielle (2),
- le dopage, avant gravure de la couche sacrificielle (2), d'au moins une partie de la surface (4, 5) d'au moins l'une des couches (1, 3) en contact avec la couche sacrificielle (2) et,
- après gravure de la couche sacrificielle (2), une phase de gravure superficielle de ladite surface (4, 5), de manière à augmenter la rugosité de la partie dopée de la surface (4, 5),
procédé **caractérisé en ce qu'**il comporte, avant dopage, le dépôt d'un masque (9) sur au moins une partie prédéterminée de la couche utile (1), de manière à délimiter au moins une zone dopée et au moins une zone non-dopée de ladite surface (4, 5), l'une desdites zones constituant une butée (6, 7) après la phase de gravure superficielle.

2. Procédé selon la revendication 1, **caractérisé en ce que**, ladite surface (4, 5) comportant intrinsèquement des éléments dopants d'un type prédéterminé, le dopage est effectué par des éléments dopants de même type, la butée (6, 7) étant constitué par la zone non-dopée.

3. Procédé selon la revendication 1, **caractérisé en ce que**, ladite surface (4, 5) comportant intrinsèquement des éléments dopants d'un type prédéterminé, le dopage est effectué par des éléments dopants de type opposé, la butée (6, 7) étant constitué par la zone dopée.

4. Procédé selon l'une quelconque des revendications 1 à 3, **caractérisé en ce que** le masque (9) est délimité par photolithographie.

5. Procédé selon la revendication 4, **caractérisé en ce que** la photolithographie a une résolution de l'ordre de 0,3 micromètres.

6. Procédé selon l'une quelconque des revendications 1 à 5, **caractérisé en ce qu'**il comporte, après dopage, une étape d'épitaxie augmentant l'épaisseur de la couche utile (1).

7. Procédé selon l'une quelconque des revendications 1 à 6, **caractérisé en ce que** le dopage est effectué par implantation ionique, les éléments dopants étant pris dans le groupe comprenant le Bore, le Phosphore et l'Arsenic.

8. Procédé selon l'une quelconque des revendications 1 à 7, **caractérisé en ce que** la gravure superficielle est effectuée par une solution aqueuse comportant du K₂Cr₂O₇ et du HF.

9. Procédé selon l'une quelconque des revendications 1 à 8, **caractérisé en ce que** la couche sacrificielle (2) est gravée complètement avant la phase de gravure superficielle de ladite surface (4, 5).

10. Procédé selon l'une quelconque des revendications 1 à 8, **caractérisé en ce qu'**il comporte
- après dopage et avant la phase de gravure superficielle de ladite surface (4, 5), la gravure partielle de la couche sacrificielle (2), de manière à laisser subsister entre la couche (3) constituant le substrat et la couche utile (1) au moins un pavé (8) espaceur,
- la phase de gravure superficielle de ladite surface (4, 5) utilisant le pavé (8) espaceur comme masque, de façon à former au moins une butée (6, 7) dans ladite surface (4, 5),
- l'enlèvement dudit pavé (8) espaceur,
- une phase supplémentaire de gravure superficielle de ladite surface (4, 5), de manière à augmenter la rugosité de la surface de la butée (6, 7).

11. Composant comportant une couche utile (1) suspendue, rattachée par des moyens de fixation à un substrat, **caractérisé en ce qu'**il est obtenu par un procédé selon l'une quelconque des revendications 1 à 10.

## Claims

1. Method for separating a useful layer (1), initially attached by a sacrificial layer (2) to a layer (3) forming a substrate, method comprising
- at least partial etching of the sacrificial layer (2),
- doping, before etching of the sacrificial layer (2), of at least a part of the surface (4, 5) of at least one of the layers (1, 3) in contact with the sacrificial layer (2) and,
- after etching of the sacrificial layer (2), a superficial etching phase of said surface (4, 5) so as to increase the roughness of the doped part of the surface (4, 5),
method **characterized in that** it comprises deposition, before doping, of a mask (9) on at least a predetermined part of the useful layer (1) so as to delineate at least one doped zone and at least one non-doped zone of said surface (4, 5), one of said zones forming a stop (6, 7) after the superficial etching phase.

2. Method according to claim 1, **characterized in that**, said surface (4, 5) intrinsically comprising doping elements of a predetermined type, doping is performed by doping elements of the same type, the stop (6, 7) being formed by the non-doped zone.

3. Method according to claim 1, **characterized in that**, said surface (4, 5) intrinsically comprising doping elements of a predetermined type; doping is performed by doping elements of opposite type, the stop (6, 7) being formed by the doped zone.

4. Method according to any one of the claims 1 to 3, **characterized in that** the mask (9) is delineated by photolithography.

5. Method according to claim 4, **characterized in that** the photolithography has a resolution of about 0.3 micrometers.

6. Method according to any one of the claims 1 to 5, **characterized in that** it comprises, after doping, an epitaxy step increasing the thickness of the useful layer (1).

7. Method according to any one of the claims 1 to 6, **characterized in that** doping is performed by ion implantation, the doping elements being taken from the group comprising Boron, Phosphorous and Arsenic.

8. Method according to any one of the claims 1 to 7, **characterized in that** superficial etching is performed by an aqueous solution containing K₂Cr₂O₇ and HF.

9. Method according to any one of the claims 1 to 8, **characterized in that** the sacrificial layer (2) is completely etched before the superficial etching phase of said surface (4, 5).

10. Method according to any one of the claims 1 to 8, **characterized in that** it comprises
- after doping and before the superficial etching phase of said surface (4, 5), partial etching of the sacrificial layer (2) so as to leave at least one spacer block (8) between the layer (3) forming the substrate and the useful layer (1),
- the superficial etching phase of said surface (4, 5) using the spacer block (8) as mask, so as to form at least one stop (6, 7) in said surface (4, 5), removal of said spacer block (8),
- an additional superficial etching phase of said surface (4, 5) so as to increase the roughness of the surface of the stop (6, 7).

11. Component comprising a suspended useful layer (1), attached by fixing means to a substrate, **characterized in that** it is obtained by a method according to any one of the claims 1 to 10.

## Patentansprüche

1. Verfahren zur Trennung einer Nutzschicht (1), die zunächst mittels einer Opferschicht (2) mit einer ein Substrat bildenden Schicht (3) verbunden ist, Verfahren, das folgende Schritte umfasst:
- ein zumindest partielles Ätzen der Opferschicht (2),
- vor dem Ätzen der Opferschicht (2) die Dotierung mindestens eines Teils der Seite (4, 5) mindestens einer der Schichten (1, 3), die in Kontakt sind mit der Opferschicht (2), und
- nach dem Ätzen der Opferschicht (2) ein Schritt des Oberflächenätzens der genannten Seite (4, 5) zur Erhöhung der Rauheit des dotierten Bereichs der Seite (4, 5).
Verfahren, das **dadurch gekennzeichnet ist, dass** vor dem Dotieren das Aufbringen einer Maske (9) auf mindestens einen vorbestimmten Bereich der Nutzschicht (1) umfasst, sodass mindestens ein dotierter und ein nichtdotierter Bereich der genannten Seite (4, 5) entstehen, wobei einer dieser Bereiche nach dem Oberflächenätzen einen Anschlag (6, 7) bildet.

2. Verfahren nach Anspruch 1, **dadurch gekennzeichnet, dass**, nachdem die genannte Seite (4, 5) intrinsisch Dotierungselemente eines vorbestimmten Typs umfasst, die Dotierung mit Dotierungselementen gleichen Typs vorgenommen wird, wobei der Anschlag (6, 7) von dem nichtdotierten Bereich gebildet wird.

3. Verfahren nach Anspruch 1, **dadurch gekennzeichnet, dass**, nachdem die genannte Seite (4, 5) intrinsisch Dotierungselemente eines vorbestimmten Typs umfasst, die Dotierung mit Dotierungselementen entgegengesetzten Typs vorgenommen wird, wobei der Anschlag (6, 7) von dem dotierten Bereich gebildet wird.

4. Verfahren nach einem der Ansprüche 1 bis 3, **dadurch gekennzeichnet, dass** die Maske (9) durch Fotolithographie begrenzt wird.

5. Verfahren nach Anspruch 4, **dadurch gekennzeichnet, dass** die Fotolithographie eine Auflösung von etwa 0,3 Mikrometern hat.

6. Verfahren nach einem der Ansprüche 1 bis 5, **dadurch gekennzeichnet, dass** es nach der Dotierung einen Epitaxieschritt umfasst, der die Dicke der Nutzschicht (1) erhöht.

7. Verfahren nach einem der Ansprüche 1 bis 6, **dadurch gekennzeichnet, dass** die Dotierung durch loneneinpflanzung vorgenommen wird, wobei die Dotierungselemente aus der von Bor, Phosphor und Arsen gebildeten Gruppe ausgewählt sind.

8. Verfahren nach einem der Ansprüche 1 bis 7, **dadurch gekennzeichnet, dass** das Oberflächenätzen mittels einer wässrigen Lösung erfolgt, die K₂Cr₂O₇ und HF enthält.

9. Verfahren nach einem der Ansprüche 1 bis 8, **dadurch gekennzeichnet, dass** die Opferschicht (2) vor dem Oberflächenätzen der genannten Seite (4, 5) vollkommen geätzt wird.

10. Verfahren nach einem der Ansprüche 1 bis 8, **dadurch gekennzeichnet, dass** es folgende Schritte umfasst:
- ein partielles Ätzen der Opferschicht (2) nach dem Dotieren und vor dem Oberflächenätzen der Seite (4, 5), sodass zwischen der das Substrat bildenden Schicht (3) und der Nutzschicht (1) mindestens ein Abstandshalter (8) bestehen bleibt,
- die Verwendung des Abstandshalters (8) als Maske in den Schritt des Oberflächenätzens der Seiten (4, 5), um in der Seite (4, 5) mindestens einen Anschlag (6, 7) zu bilden,
- das Entfernen des Abstandshalters (8),
- einen zusätzlichen Schritt des Oberflächenätzens der genannten Seite (4, 5) zur Erhöhung der Rauheit der Oberfläche des Anschlags (6, 7).

11. Bauteil, das eine aufgehängte Nutzschicht (1) umfasst, die durch Fixierungsmittel mit einem Substrat verbunden ist, **dadurch gekennzeichnet, dass** es mit einem Verfahren nach einem der Ansprüche 1 bis 10 hergestellt wird.
